# EUROPÄISCHE PATENTSCHRIFT

(11) **EP 0 428 774 B1**
(45) Veröffentlichungstag und Bekanntmachung des Hinweises auf die Patenterteilung: **21.09.1994**
(21) Anmeldenummer: 89121534.5
(22) Anmeldetag: 21.11.1989
(51) Int. Cl.: G06F 1/08, H03K 3/023

(54) **Mikrocomputer mit einem intergrierten RC-Oszillator mit programmierbarer Frequenz**
Microcomputer with an integrated RC oscillator having programmable frequencies
Micro-ordinateur avec un oscillateur RC intégré à fréquence programmable

(43) Veröffentlichungstag der Anmeldung: 29.05.1991
(73) Patentinhaber: SIEMENS AKTIENGESELLSCHAFT, 80333 München (DE)
(72) Erfinder: Möller, Udo, Dipl.-Ing., D-4100 Duisburg (DE); Renner, Martin, Dipl.-Ing., D-4020 Mettmann (DE)

(56) Entgegenhaltungen:
- WO-A-85/02275
- US-A- 4 723 114
- US-A- 4 868 525
- U. TIETZE et al.: "Halbleiter - Schaltungstechnik", 8. Auflage, 1986, Seite177, Abbildung 8.31

## Beschreibung

Die Erfindung betrifft einen monolithisch integrierten, mit einem Prozessortakt getakteten Mikrocomputer mit mindestens einer zentralen Verarbeitungseinheit und mit mindestens einer asynchron zum Prozessortakt arbeitenden Funktionseinheit, die durch einen Taktgenerator gesteuert wird, der durch externe Signale synchronisierbar ist und der in Form eines RC-Oszillators realisiert ist.

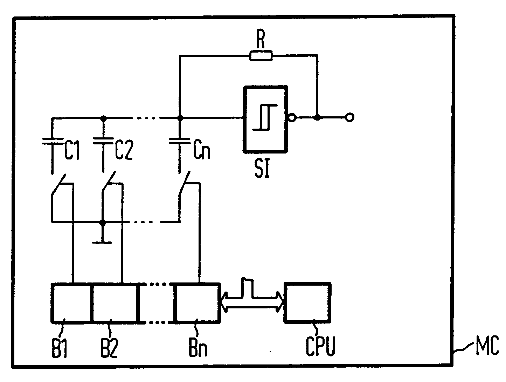

Beispielsweise wird ein solcher Mikrocomputer benötigt, wenn er neben den üblichen Funktionen eines Mikrocomputers auch ermöglichen soll, Texte und Grafiken in ein RGB-Video-Signal, beispielsweise ein Fernsehbild, einzublenden. Hierzu sind Mikrocomputer bekannt, die mit einem RC-Oszillator arbeiten, deren Schmitt-Trigger-Inverter integriert ist, bei denen allerdings extern die frequenzbestimmende Kapazität und ein Rückkopplungswiderstand angeschaltet werden. Ein Multivibrator mit invertierendem Schmitt-Trigger ist unter anderem aus U. Tietze/Ch. Schenk, Halbleiter-Schaltungstechnik, 8. , überarbeitete Auflage, 1986 auf Seite 177, Abbildung 8.31 sowie zugehöriger Beschreibung bekannt. Hierbei bildet der Ausgang eines invertierenden Schmitt-Triggers den Ausgang des Oszillators und ist über einen frequenzbestimmenden Widerstand an den Eingang des Schmitt-Triggers rückgekoppelt. Außerdem ist der Eingang des Schmitt-Triggers über eine frequenzbestimmende Kapazität an ein Bezugspotential geschaltet.

Aus dem Artikel PCF84C640 specification, Version 1.0 von J.C.P.M. Pijnenburg, veröffentlicht in Philipps Laboratory Report Number DPE 87221 vom 16.11.1987 ist ein gattungsgemäßer Mikrocomputer bekannt, wobei insbesondere auf Seite R21 in Figur 20 eine asynchron zum Prozessortakt arbeitende, durch einen durch externe Signale synchronisierbaren Taktgenerator gesteuerte Funktionseinheit gezeigt ist, in diesem Falle eine DOSEinheit (Display on screen). Der gezeigte Mikrocomputer beinhaltet einen RC-Oszillator mit einem extern angeschlossenen SerienRC-Glied, wobei der Verbindungsknoten zwischen dem Widerstand und der Kapazität dieses externen RC-Gliedes an den integrierten Mikrocomputer angeschlossen ist und der Widerstand des RC-Gliedes mit dem Versorgungspotential des Mikrocomputers zusammengeschaltet ist und die Kapazität des RC-Gliedes an das Bezugspotential des Mikrocomputers geschaltet ist.

Aus dem Datenblatt der Fa. Mitsubishi Electric des Mitsubishi Mikrocomputer M50433B-XXXSP ist ebenfalls ein gattungsgemäßer Mikrocomputer bekannt, wobei der Ausgang eines RC-Oszillators über einen extern anschaltbaren, veränderbaren Widerstand an seinen Eingang rückgekoppelt wird und der Eingang dieses RC-Oszillators über eine Kapazität an das Bezugspotential des Mikrocomputers geschaltet ist.

Die Frequenz des Oszillators wird bei solchen bekannten Mikrocomputern jeweils direkt durch die Parameter des externen Widerstandes und der externen Kapazität bestimmt, wodurch Schwankungen dieser Parameter, die durch Typenstreuungen, Temperaturabhängigkeiten oder Alterungseffekte auftreten können, zu einer unerwünschten Veränderung der Frequenz führen. Um eine definierte Betriebsfrequenz zu erreichen, sind daher bei der Gerätefertigung entsprechende Abstimmaßnahmen erforderlich. Außerdem ist für das Anschließen dieser externen Schaltelemente mindestens ein Kontakt erforderlich, was sich sowohl in der benötigten Chipfläche als auch im Preis des benötigten Gehäuses bemerkbar macht.

In der US-Patentschrift 4,723,114 ist ein auf einem integrierten Halbleiterchip realisierbarer RC-Oszillator gezeigt.

Der Oszillator weist eine Anzahl von Kondensatoren auf, die wahlweise parallel geschaltet werden können, um die Zeitkonstante zu verändern.

Aufgabe der Erfindung ist das Bereitstellen eines monolithisch integrierten Mikrocomputers der eingangs beschriebenen Art, bei dem diese Nachteile nicht auftreten.

Diese Aufgabe wird dadurch gelöst, daß der frequenzbestimmende Widerstand sowie die frequenzbestimmende Kapazität des RC-Oszillators monolithisch integriert sind, daß die frequenzbestimmende Kapazität durch eine Vielzahl schaltbarer Kapazitäten realisiert ist, die zu einer Gesamtkapazität variabler Größe zusammenschaltbar sind und daß die Frequenzeinstellung des Taktgenerators über das Setzen entsprechender, den Schaltzustand der schaltbaren Kapazitäten festlegender Register durch die zentrale Verarbeitungseinheit erfolgt.

Günstige Ausgestaltungsformen sind Gegenstand von Unteransprüchen.

Bei einem erfindungsgemäßen Mikrocomputer MC ist zur Frequenzeinstellung des durch externe Signale synchronisierbaren Taktgenerators kein außerhalb des Mikrocomputers befindliches Bauelement und somit zu dessen Anschluß an den Mikrocomputer MC auch kein Anschlußpad auf dem Halbleiterchip erforderlich. Da bei moderner Halbleitertechnologie die Größe des Halbleiterchips maßgeblich durch die Anzahl der Anschlußpads festgelegt wird, benötigt ein erfindungsgemäßer Mikrocomputer gegenüber einem Mikrocomputer mit externem RC-Glied trotz größeren Schaltungsaufwandes weniger Chipfläche.

Ein großer Vorteil erfindungsgemäßer Mikrocomputer gegenüber zum Stande der Technik gehörenden Mikrocomputern liegt darin, daß keine manuelle Frequenzabstimmung erforderlich ist und temperaturänderungs- oder alterungsbedingte Parameter-Schwankungen sich nicht negativ auf die Frequenzabstimmung auswirken. Außerdem kann die Frequenz des Taktgenerators während des Betriebes des Mikrocomputers variiert werden.

Bei einem günstigen Ausführungsbeispiel eines erfindungsgemäßen Mikrocomputer MC wird die Frequenzabstimmung des durch externe Signale synchronisierbaren Taktgenerators im Rahmen eines Test-Zyklus durchgeführt. Der Zähler der zentralen Verarbeitungseinheit CPU zählt hierbei während einer definierten Zeitdauer die Anzahl der Takte des Taktgenerators. Aufgrund dieses Zählergebnisses werden dann von der zentralen Verarbeitungseinheit CPU unter Berücksichtigung der bisherigen Registerinhalte und somit der bisherigen Gesamtkapazität die erforderlichen Registerinhalte berechnet und die den Schaltzustand der schaltbaren Kapazitäten C1, C2, ..., Cn festlegenden Register B1, B2, ..., Bn entsprechend gesetzt.

In einem günstigen Ausführungsbeispiel wird die definierte Zeitdauer, während der die Takte des Taktgenerators gezählt werden, in Abhängigkeit vom Prozessortakt festgelegt.

Selbstverständlich ist dem Fachmann klar, daß eine Veränderung der Frequenz des Taktgenerators auch durch Veränderung des frequenzbestimmenden Widerstandes R am RC-Oszillator erreicht werden kann. Daher ist es zum Gegenstand des Patentanspruches 1 äquivalent, wenn der frequenzbestimmende Widerstand R aus mehreren, schaltbaren Teilwiderständen besteht, die bedarfsweise zusammengeschaltet werden können.

Eine besonders günstige und chipflächensparende Ausführungsform sieht jedoch vor, daß verschieden große Kapazitäten C1, C2,..., Cn parallelschaltbar sind.

Nachstehend wird der erfindungswesentliche Schaltungsteil anhand des in der Figur in Form eines Prinzipschaltbildes dargestellten Ausführungsbeispieles näher erläutert. Die Figur zeigt als Blockschaltbild einen Mikrocomputer MC, wobei die meisten Komponenten eines gattungsgemäßen Mikrocomputers, wie sie unter anderem aus den oben genannten Druckschriften bekannt sind, aufgrund der besseren Übersichtlichkeit weggelassen worden sind. Dargestellt ist der RC-Oszillator eines erfindungsgemäßen Taktgenerators, bestehend aus einem Schmitt-Trigger-Invertierer SI, dessen Ausgang den Ausgang des RC-Oszillators bildet und dessen Ausgang über einen Widerstand R an seinen Eingang rückgekoppelt ist. Außerdem ist der Eingang des Schmitt-Trigger-Oszillator SE über eine Vielzahl parallelgeschalteter schaltbarer Kapazitäten C1, C2, ..., Cn an das Bezugspotential schaltbar. Der Steuereingang des Schalters jeder der schaltbaren Kapazitäten C1, C2, ..., Cn ist jeweils an ein Register B1, B2, ..., Bn angeschlossen, wobei die Schalterstellung vom Registerinhalt abhängt. Außerdem ist eine zentrale Verarbeitungseinheit CPU gezeigt, die unter anderem den Inhalt der besagten Register B1, B2, ..., Bn lesen kann und auch verändern kann.

Bei einer in der Figur gezeigten Schaltung kann die Frequenzeinstellung des RC-Oszillators über die Register B1, B2, ..., Bn durch die zentrale Verarbeitungseinheit CPU erfolgen, wobei der Prozessortakt, der beispielsweise durch einen Quarz-Oszillator oder einen Oberflächenwellenfilter-Oszillator erzeugt wird, als Referenz dienen kann. Durch wiederholte automatische Abstimmung während des Betriebes können Frequenzänderungen des RC-Oszillators, die beispielsweise durch Temperaturschwankungen zustande kommen, ausgeglichen werden. Fertigungsbedingte Abweichungen des frequenzbestimmenden Widerstandes oder der einzelnen frequenzbestimmenden Kapazitäten wirken sich aus diesem Grunde ebenfalls nicht aus.

## Patentansprüche

1. Monolithisch integrierter, mit einem Prozessortakt getakter Mikrocomputer (MC) mit einer zentralen Verarbeitungseinheit (CPU) und mit mindestens einer asynchron zum Prozessortakt arbeitenden Funktionseinheit, die durch einen Taktgenerator gesteuert wird, der durch externe Signale synchronisierbar ist und der in Form eines RC-Oszillators realisiert ist,
**dadurch gekennzeichnet,**
daß der frequenzbestimmende Widerstand (R) sowie die frequenzbestimmende Kapazität (C1, C2,..., Cn) des RC-Oszillators monolithisch integriert sind, daß die frequenzbestimmende Kapazität (C1, C2, ..., Cn) durch eine Vielzahl schaltbarer Kapazitäten (C1, C2, ..., Cn) realisiert ist, die zu einer Gesamtkapazität variabler Größe zusammenschaltbar sind und daß die Frequenzeinstellung des Taktgenerators über das Setzen entsprechender, den Schaltzustand der schaltbaren Kapazitäten (C1, C2, ..., Cn) festlegender Register (B1, B2, ..., Bn) durch die zentrale Verarbeitungseinheit (CPU) erfolgt.

2. Mikrocomputer (MC) nach Anspruch 1,
**dadurch gekennzeichnet,**
daß der Prozessortakt als Referenz für die Frequenzeinstellung des Takgenerators vorgesehen ist.

3. Mikrocomputer (MC) nach einem der vorhergehenden Ansprüche,
**dadurch gekennzeichnet**,
daß die schaltbaren Kapazitäten (C1, C2, ..., Cn) unterschiedliche Werte aufweisen.

4. Mikrocomputer (MC) nach einem der vorhergehenden Ansprüche,
**dadurch gekennzeichnet,**
daß die schaltbaren Kapazitäten (C1, C2, ..., Cn) zueinander parallel geschaltet sind.

5. Mikrocomputer (MC) nach einem der vorhergehenden Ansprüche, **dadurch gekennzeichnet,** daß als RC-Oszillator ein über inen Widerstand (R) rückgekoppelter Schmitt-Trigger-Inverter (SI) vorgesehen ist, zwischen dessen Eingang und einem Bezugspotential die schaltbaren Kapazitäten (C1, C2, ..., Cn) schaltbar sind.

6. Mikrocomputer (MC) nach einem der vorhergehenden Ansprüche, **dadurch gekennzeichnet,** daß der Schaltzustand jeder der schaltbaren Kapazitäten (C1, C2, ..., Cn) vom Dateninhalt eines speziellen Registers (B1, B2, ..., Bn) abhängt.

7. Mikrocomputer (MC) nach einem der Ansprüche 1 bis 5, **dadurch gekennzeichnet**, daß die schaltbaren Kapazitäten (C1, C2, ..., Cn) von Registern über einen Decoder angesteuert werden, wobei jeder denkbaren Kombination von Registerinhalten eine spezielle Gesamtkapazität zuordenbar ist.

## Claims

1. Monolithically integrated microcomputer (MC) clocked by a processor clock, having a central processing unit (CPU) and having at least one functional unit which operates asynchronously to the processor clock and is controlled by a clock generator which can be synchronized by external signals and which is realized in the form of an RC oscillator, characterized in that the frequency-determining resistor (R) as well as the frequency-determining capacitor (C1, C2, ..., Cn) of the RC oscillator are monolithically integrated, in that the frequency-determining capacitor (C1, C2, ..., Cn) is realized by a plurality of switchable capacitors (C1, C2, ..., Cn) which can be interconnected to form a total capacitance of variable magnitude, and in that the frequency of the clock generator is adjusted by the setting of corresponding registers (B1, B2, ..., Bn) which define the switching state of the switchable capacitors (C1, C2, ..., Cn) by the central processing unit (CPU).

2. Microcomputer (MC) according to Claim 1, characterized in that the processor clock is provided as reference for the frequency adjustment of the clock generator.

3. Microcomputer (MC) according to one of the preceding claims, characterized in that the switchable capacitors (C1, C2, ..., Cn) have different values.

4. Microcomputer (MC) according to one of the preceding claims, characterized in that the switchable capacitors (C1, C2, ..., Cn) are connected parallel to one another.

5. Microcomputer (MC) according to one of the preceding claims, characterized in that a Schmitt trigger inverter (SI) fed back via a resistor (R) is provided as RC oscillator, it being possible to switch the switchable capacitors (C1, C2, ..., Cn) between the input of said inverter and a reference potential.

6. Microcomputer (MC) according to one of the preceding claims, characterized in that the switching state of each of the switchable capacitors (C1, C2, ..., Cn) depends on the data contents of a specific register (B1, B2, ..., Bn).

7. Microcomputer (MC) according to one of Claims 1 to 5, characterized in that the switchable capacitors (C1, C2, ..., Cn) are driven by registers via a decoder, it being possible to assign a specific total capacitance to every conceivable combination of register contents.

## Revendications

1. Micro-ordinateur intégré monolithique (MC) commandé de façon cadencée par une cadence de processeur, comportant une unité centrale de traitement (CPU) et au moins une unité fonctionnelle travaillant de façon asynchrone par rapport à la cadence de processeur et qui est commandée par un générateur de cadence, qui peut être synchronisé par des signaux externes et qui est réalisé sous la forme d'un oscillateur RC,
caractérisé par le fait que la résistance (R), qui détermine la fréquence, ainsi que la capacité (C1, C2, ..., Cn), qui détermine la fréquence, de l'oscillateur RC sont intégrées de façon monolithique, que la capacité (C1, C2, ..., Cn), qui détermine la fréquence, est constituée par une multiplicité de capacités commutables (C1, C2, ..., Cn), qui peuvent être interconnectées pour former une capacité totale de grandeur variable et que le réglage de la fréquence du générateur de cadence s'effectue par le positionnement de registres correspondants (B1, B2, ..., Bn), qui fixent l'état de commutation des capacités commutables (C1, C2, ..., Cn), au moyen de l'unité centrale de traitement (CPU).

2. Micro-ordinateur (MC) suivant la revendication 1, caractérisé par le fait que la cadence de processeur est prévue en tant que référence pour le réglage de la fréquence du générateur de cadence.

3. Micro-ordinateur (MC) suivant l'une des revendications précédentes, caractérisé par le fait que les capacités commutables (C1, C2, ..., Cn) possèdent des valeurs différentes.

4. Micro-ordinateur (MC) suivant l'une des revendications précédentes, caractérisé par le fait que les capacités commutables (C1, C2, ..., Cn) sont branchées en parallèle l'une à l'autre.

5. Micro-ordinateur (MC) suivant l'une des revendications précédentes, caractérisé par le fait qu'il est prévu, en tant qu'oscillateur RC, un déclencheur-inverseur de Schmitt (SI), couplé par réaction par l'intermédiaire d'une résistance (R), les capacités commutables (C1, C2, ..., Cn) pouvant être commutées entre l'entrée de ce déclencheur-inverseur et un potentiel de référence.

6. Micro-ordinateur (MC) suivant l'une des revendications précédentes, caractérisé par le fait que l'état de commutation de chacune des capacités commutables (C1, C2,..., Cn) dépend du contenu des données d'un registre spécial (B1, B2, ..., Bn).

7. Micro-ordinateur (MC) suivant l'une des revendications 1 à 5, caractérisé par le fait que les capacités commutables (C1, C2, ..., Cn) sont commandées par des registres, par l'intermédiaire d'un décodeur, une capacité globale spéciale pouvant être associée à chaque combinaison imaginable de contenus de registres.
